# EUROPÄISCHE PATENTANMELDUNG

(11) **EP 1 498 947 A2**
(43) Veröffentlichungstag der Anmeldung: **19.01.2005**
(21) Anmeldenummer: 04015076.5
(22) Anmeldetag: 26.06.2004
(51) Int. Cl.: H01L 23/16, H01L 23/34

(54) **Elektronische Schaltung mit einem Leistungshalbleiterbauelement und mit einem Sicherungsmittel zum Schutz des Leistungshalbleiterbauelements vor Überhitzung**

(30) Priorität: 15.07.2003 DE 10331923
(71) Anmelder: Behr-Hella Thermocontrol GmbH, D-70469 Stuttgart (DE)
(72) Erfinder: Knittel, Otto, Dipl.-Ing., 59494 Soest (DE); Schröer, Burkhard, 58706 Menden (DE)
(74) Vertreter: Graefe, Jörg

(57) **Zusammenfassung**

Elektronische Schaltung (1) mit einem Leistungshalbleiterbauelement (2) und mit einem Sicherungsmittel zum Schutz des Leistungshalbleiterbauelements vor Überhitzung umfassend folgende Merkmale: die Schaltung (1) umfasst das Leistungshalbleiterbauelement (2), ein Halbleiterbauelement (3), einen Schaltungsträger (4) und einen Kühlkörper (5); das Leistungshalbleiterbauelement (2) ist mit einer metallischen Gehäusefläche an dem Kühlkörper (5) wärmeleitend angebracht; das Halbleiterbauelement (3) weist das Sicherungsmittel mit einem Temperatursensor auf, das beim Überschreiten einer Temperatur das Leistungshalbleiterbauelement (2) abschaltet; das Halbleiterbauelement (3) ist mit einer metallischen Gehäusefläche an einer ersten Stelle (6) des Schaltungsträgers (4) wärmeleitend angebracht; der Kühlkörper ist an einer zweiten Stelle (7) des Schaltungsträgers (4) wärmeleitend angebracht; die erste Stelle (6) und die zweite Stelle (7) des Schaltungsträgers (4) sind wärmeleitend miteinander verbunden.

## Beschreibung

Die Erfindung betrifft eine elektronische Schaltung mit einem Leistungshalbleiterbauelement und mit einem Sicherungsmittel zum Schutz des Leistungshalbleiterbauelementes vor Überhitzung.

Aus dem Stand der Technik sind derartige elektronische Schaltungen bekannt. Dabei sind die Sicherungsmittel zum Schutz des Leistungshalbleiterbauelementes vor Überhitzung zumeist unmittelbar in dem Leistungshalbleiterbauelement ausgestaltet. Ein derartiges Leistungshalbleiterbauelement mit dem Sicherungsmittel ist jedoch deutlich aufwändiger und daher auch teurer als ein herkömmliches Leistungshalbleiterbauelement ohne ein solches Sicherungsmittel.

Der Erfindung liegt daher die Aufgabe zugrunde, eine elektronische Schaltung vorzuschlagen, die ein Leistungshalbleiterbauelement aufweist, welches ein Standard-Leistungshalbleiterbauelement ist, und die über ein Sicherungsmittel zum Schutz des Leistungshalbleiterbauelementes vor Überhitzung verfügt.

Diese Aufgabe wird erfindungsgemäß durch eine elektronische Schaltung gemäß Anspruch 1 gelöst. Bei einer erfindungsgemäßen elektronischen Schaltung ist das Leistungshalbleiterbauelement mit einer metallischen Gehäusefläche an einem Kühlkörper wärmeleitend angebracht. Die elektronische Schaltung verfügt über ein Halbleiterbauelement, das das Sicherungsmittel mit einem Temperatursensor aufweist. Beim Überschreiten einer vorbestimmten Temperatur schaltet das Sicherungsmittel in dem Halbleiterbauelement das Leistungshalbleiterbauelement ab. Das Halbleiterbauelement ist mit einer metallischen Gehäusefläche an einer ersten Stelle an einem Schaltungsträger angebracht. Der Kühlkörper, an welchem das Leistungshalbleiterbauelement angebracht ist, ist an einer zweiten Stelle des Schaltungsträgers wärmeleitend angebracht. Damit das Sicherungsmittel in dem Halbleiterbauelement die Temperatur des Leistungshalbleiterbauelementes zuverlässig und möglichst ohne große Verzögerung erfassen kann, sind die erste Stelle und die zweite Stelle des Schaltungsträgers wärmeleitend miteinander verbunden.

Die erfindungsgemäße Schaltung kann einen Schaltungsträger aufweisen, der eine Ausnehmung hat, wobei das Leistungshalbleiterbauelement, welches auf dem Kühlkörper befestigt ist, diese Ausnehmung des Schaltungsträgers durchgreift.

Der Schaltungsträger einer erfindungsgemäßen Schaltung kann eine erste Seite haben, die die erste Stelle umfasst, an welcher das Halbleiterbauelement an dem Schaltungsträger befestigt ist.

Der Schaltungsträger einer erfindungsgemäßen Schaltung kann ferner eine zweite Seite haben, welche die zweite Stelle umfasst, an welcher der Kühlkörper des Schaltungsträgers wärmeleitend befestigt ist.

Gemäß der Erfindung kann die erste Stelle und die zweite Stelle über wärmeleitende Kontaktierungen in dem Schaltungsträger verbunden sein.

Das Leistungsbauelement kann ein Leistungstransistor sein, mit welchem beispielsweise ein Gebläsemotor in einem Kraftfahrzeug gesteuert wird.

Der Temperatursensor, welcher in dem Halbleiterbauelement vorgesehen ist, ist elektrisch isoliert und vorteilhaft galvanisch isoliert mit der metallischen Außenfläche des Halbleiterbauelementes wärmeleitend verbunden. Das Halbleiterbauelement kann im Übrigen ein ASIC sein.

Zur Herstellung einer erfindungsgemäßen elektronischen Schaltung, wird zunächst die Fläche des Kühlkörpers, die mit dem Schaltungsträger bzw. dem Leistungshalbleiterbauelement verbunden wird, mittels eines Kaltgasspritzverfahrens mit Kupfer beschichtet. Danach wird das Leistungshalbleiterbauelement und der Schaltungsträger auf diese Seite des Kühlkörpers aufgelegt. Schließlich wird das Halbleiterbauelement auf eine mit einer lötfähigen Beschichtung versehene ersten Stelle des Schaltungsträgers angebracht. Die so zusammengesetzte Schaltung wird dann in einem einzigen Lötprozess nämlich einem Dampfphasenlötverfahren verlötet, wobei der Leistungshalbleiter und der Schaltungsträger auf dem Kühlkörper und das Halbleiterbauelement auf dem Schaltungsträger angelötet wird.

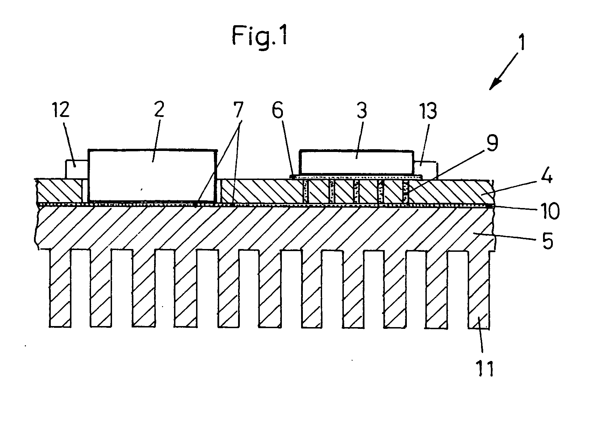

Ein Ausführungsbeispiel für eine erfindungsgemäße elektronische Schaltung mit einem Leistungshalbleiterbauelement und mit einem Sicherungsmittel zum Schutz des Leistungshalbleiterbauelements vor Überhitzung ist anhand der Zeichnung näher beschrieben. Darin zeigt, die einzige
- Fig. 1: einen Schnitt durch die erfindungsgemäße elektronische Schaltung.

Die in der Figur dargestellte elektronische Schaltung weist einen Schaltungsträger 4 auf, an dessen Unterseite ein Kühlkörper 5 mit Kühlrippen 11 unter Zwischenschaltung einer Lötschicht 10 vollflächig angelötet ist. Die Unterseite des Schaltungsträgers 4 ist dazu entsprechend beschichtet (zweite Stelle 7), so dass mit der Unterseite des Schaltungsträgers eine lötfähige Verbindung hergestellt werden kann.

Der Schaltungsträger 4 weist eine Ausnehmung auf, durch welche ein auf dem Kühlkörper 5 befestigtes Leistungshalbleiterbauelement 2 hindurchragt.

Auch die Oberseite des Schaltungsträgers 4 ist lötfähig beschichtet (erste Stelle 6), so dass auf der Oberseite des Schaltungsträgers 4 ein Halbleiterbauelement 3 angebracht sein kann. Die Oberseite des Schaltungsträgers 4 ist dabei jedoch nicht vollflächig beschichtet, sondern nur an einer ersten Stelle 6 und darüber hinaus in nicht näher dargestellten Bereichen, in welchen Anschlussbeinchen 12 des Leistungshalbleiterbauelementes 2 und Anschlussbeinchen 13 des Halbleiterbauelementes 3 mit dem Schaltungsträger 4 verbunden sind. Sowohl das Leistungshalbleiterbauelement 2 als auch das Halbleiterbauelement 3 haben auf ihrer unteren, dem Kühlkörper 5 bzw. dem Schaltungsträger 4 zugewandten Gehäusefläche einen metallischen Boden, welcher die wärmeleitende Verbindung des Leistungshalbleiterbauelementes 2 mit dem Kühlkörper 5 bzw. des Halbleiterbauelementes 3 mit der ersten Stelle 6 verbessern. Die zweite Stelle 7, an welcher der Kühlkörper 5 an dem Schaltungsträger 4 angelötet ist, ist über Durchkontaktierungen 9 mit der ersten Stelle 6 verbunden, an welcher das Halbleiterbauelement 3 an dem Schaltungsträger 4 angebracht ist.

In dem Halbleiterbauelement 3 ist ein Sicherungsmittel ausgebildet, welches einen Temperatursensor umfasst. Dieser Temperatursensor ist mit dem Gehäuseboden des Halbleiterbauelementes 3 verbunden. Dieses geschieht vorzugsweise unter Zwischenschaltung einer elektrisch, insbesondere galvanisch isolierenden Trennschicht. Das Sicherungsmittel bewirkt, bei dem Überschreiten eines Temperaturschwellwerts das Abschalten des Leistungshalbleiterbauelementes 2. Ferner kann ein zweiter Schwellwert vorgesehen sein, der vorzugsweise unterhalb des ersten Schwellwerts liegt, bei dessen Erreichen mittels des Leistungshalbleiterbaulements 2 eine an das Leistungshalbleiterbauelement 2 angeschlossene Last heruntergeregelt wird. Durch die gute thermische Verbindung zwischen dem Gehäuseboden des Halbleiterbauelementes 3 über den Kühlkörper 5 und die Durchkontaktierungen 8 mit dem Gehäuseboden des Leistungshalbleiterbauelementes 2 kann die in dem Leistungshalbleiterbauelement 2 entstehende Wärme schnell und zuverlässig durch den Temperatursensor des Halbleiterbauelementes 3 erfasst werden. Dieses ermöglicht eine schnelle Abschaltung des Leistungshalbleiterbauelementes 2, so dass thermische Schäden an dem Leistungshalbleiterbauelement 2 verhindert werden, sofern das Leistungshalbleiterbauelement 2 nicht ausreichend gekühlt wird, was auf Grund eines Ausfalls eines Kühlsystems erfolgen kann.

## Patentansprüche

1. Elektronische Schaltung (1) mit einem Leistungshalbleiterbauelement (2) und mit einem Sicherungsmittel zum Schutz des Leistungshalbleiterbauelements vor Überhitzung umfassend folgende Merkmale:
- die Schaltung (1) umfasst das Leistungshalbleiterbauelement (2), ein Halbleiterbauelement (3), einen Schaltungsträger (4) und einen Kühlkörper (5);
- das Leistungshalbleiterbauelement (2) ist mit einer metallischen Gehäusefläche an dem Kühlkörper (5) wärmeleitend angebracht;
- das Halbleiterbauelement (3) weist das Sicherungsmittel mit einem Temperatursensor auf, das beim Überschreiten einer Temperatur das Leistungshalbleiterbauelement (2) abschaltet;
- das Halbleiterbauelement (3) ist mit einer metallischen Gehäusefläche an einer ersten Stelle (6) des Schaltungsträgers (4) wärmeleitend angebracht;
- der Kühlkörper ist an einer zweiten Stelle (7) des Schaltungsträgers (4) wärmeleitend angebracht;
- die erste Stelle (6) und die zweite Stelle (7) des Schaltungsträgers (4) sind wärmeleitend miteinander verbunden.

2. Schaltung nach Anspruch 1, **dadurch gekennzeichnet, dass** der Schaltungsträger (4) eine Ausnehmung aufweist, welche das Leistungshalbleiterbauelement (2) durchgreift.

3. Schaltung nach Anspruch 1 oder 2, **dadurch gekennzeichnet, dass** eine erste Seite des Schaltungsträgers (4) die erste Stelle (6) umfasst.

4. Schaltung nach einem der Ansprüche 1 bis 3, **dadurch gekennzeichnet, dass** eine zweite Seite des Schaltungsträgers (4) die zweite Stelle (7) umfasst.

5. Schaltung nach einem der Ansprüche 1 bis 4, **dadurch gekennzeichnet, dass** der Kühlkörper (5) an der zweiten Seite des Schaltungsträgers (4) vollflächig angebracht ist.

6. Schaltung nach einem der Ansprüche 1 bis 5, **dadurch gekennzeichnet, dass** die erste Stelle (6) und die zweite Stelle (7) über wärmeleitende Kontaktierungen (9) verbunden sind.

7. Schaltung nach einem der Ansprüche 1 bis 6, **dadurch gekennzeichnet, dass** das Leistungshalbleiterbauelement (2) ein Leistungstransistor ist.

8. Schaltung nach einem der Ansprüche 1 bis 7, **dadurch gekennzeichnet, dass** der Temperatursensor elektrisch isoliert und vorteilhaft galvanisch isolierend mit der metallischen Außenfläche des Halbleiterbauelements (3) verbunden ist.

9. Schaltung nach einem der Ansprüche 1 bis 8, **dadurch gekennzeichnet, dass** das Halbleiterbauelement (3) ein ASIC ist.
